**Europäisches Patentamt**

**European Patent Office**

**Office européen des brevets**

(19)

(11) Veröffentlichungsnummer: **0 175 838**
**A2**

(12) # EUROPÄISCHE PATENTANMELDUNG

(21) Anmeldenummer: **85105433.8**

(22) Anmeldetag: **03.05.85**

(51) Int. Cl.⁴: **H 03 H 9/36**
**H 03 H 9/09**

(30) Priorität: **27.09.84 DE 3435483**

(43) Veröffentlichungstag der Anmeldung:
**02.04.86 Patentblatt 86/14**

(84) Benannte Vertragsstaaten:
**BE DE FR GB IT**

(71) Anmelder: **GRUNDIG E.M.V. Elektro-Mechanische Versuchsanstalt Max Grundig holländ. Stiftung & Co. KG.**
**Kurgartenstrasse 37**
**D-8510 Fürth(DE)**

(72) Erfinder: **Dennerlein, Johannes**
**Beethovenstrasse 9**
**D-8553 Ebermannstadt(DE)**

(72) Erfinder: **Fette, Ingolf**
**Glockenstrasse 22**
**D-8510 Fuerth(DE)**

(54) Ultraschall-Verzögerungsleitung.

(57) Es wird eine Ultraschall-Verzögerungsleitung beschrieben, die aus einer dünnen ebenen Glasplatte besteht, bei der die zugeordneten elektromechanischen Wandler an einer Kontaktseite über ein längsbewegliches Kontaktfederteil kontaktiert werden.

FIG.1

EP 0 175 838 A2

- 𝒜 -

## ULTRASCHALL-VERZÖGERUNGSLEITUNG

## BESCHREIBUNG

Die Erfindung betrifft eine Ultraschall-Verzögerungsleitung mit Mehrfachreflexion aus einem Festkörper mit
Verzögerungseigenschaften, der zu einer dünnen ebenen
Platte ausgebildet ist und der vorzugsweise eine Rechteckform mit im wesentlichen parallel verlaufenden
Außenflächen aufweist, wobei an einer der beiden kleineren Außenseiten die beiden gegenüberliegenden Ecken
abgeschrägt sind und an diesen Schrägflächen jeweils
ein in einer Richtung polarisierter Eingangs- bzw.
Ausgangs-Wandler angebracht ist.

Es sind Ultraschall-Verzögerungsleitungen bekannt,
die einen festen, vorzugsweise aus Glas bestehenden

- 5 -

Laufzeit-Festkörper aufweisen und an ihren Eingangs- und Ausgangsflächen mit einem elektromechanischen Wandler versehen sind. Das am ersten Wandler ankommende elektrische Signal wird in Ultraschallwellen umgewandelt, die sich innerhalb des Laufzeitkörpers mit verminderter Geschwindigkeit fortbewegen und an der Ausgangsfläche des Laufzeitkörpers mit Hilfe eines zweiten elektromechanischen Wandlers wieder in elektrische Signale umgewandelt werden. Auf diese Weise ist es möglich, auf verhältnismäßig geringem Raum eine verhältnismäßig große Verzögerungszeit mit einfachen Mitteln zu erreichen.

Weiterhin ist bekannt, daß die aus Glas bestehenden Festkörper in einen Träger aus Kunststoff eingesetzt sind, und die elektromechanischen Wandler über eine dünne Drahtlötverbindung mit massiven Kontaktstiften des Trägers verbunden sind. Nachteilig ist hierbei, daß durch das beidseitige Anlöten der Anschlußdrähte an die Wandler eine qualitative Beeinträchtigung des Wandlers gegeben ist. Da die verwendeten Piezowandler nach dem Prinzip eines Scherschwingers arbeiten, beeinträchtigt eine beidseitig angebrachte Lötstelle das Schwingungsverhalten der schmalen streifenförmig ausgebildeten Wandler. Es sind zur Vermeidung dieses Nachteils Kontaktverbindungen an den Wandlern bekannt, die aus einem Leitkleber bestehen. Nachteilig ist hierbei, daß das Haltevermögen des Kontaktklebers nicht immer von ausreichender Sicherheit ist.

- 3 -    0175838

Die Aufgabe der Erfindung besteht darin, eine einfache elektrische Kontaktierung an den elektromechanischen Wandlern einer Ultraschall-Verzögerungsleitung zu schaffen, bei der das Schwingungsverhalten der Wandler nicht beeinträchtigt wird.

Diese Aufgabe wird erfindungsgemäß durch die im kennzeichnenden Teil des Anspruchs 1 angegebenen Merkmale gelöst.

Vorteilhafte Ausgestaltungen der erfindungsgemäßen Ultraschall-Verzögerungsleitung ergeben sich aus den Unteransprüchen.

Die Erfindung wird nachfolgend unter Bezugnahme auf die Zeichnungsfiguren näher erläutert.

Fig. 1    ist eine perspektivische Ansicht einer Ultraschall-Verzögerungsleitung mit den erfindungsgemäßen Merkmalen,

Fig. 2    ist eine Vorder- und Seitenansicht eines Kontaktfederteils, das als Z-förmige Drahtfeder ausgebildet ist und

- 7 -

Fig. 3      ist eine Ansicht eines Kontaktfederteils, das als Blattfeder ausgeführt
ist.

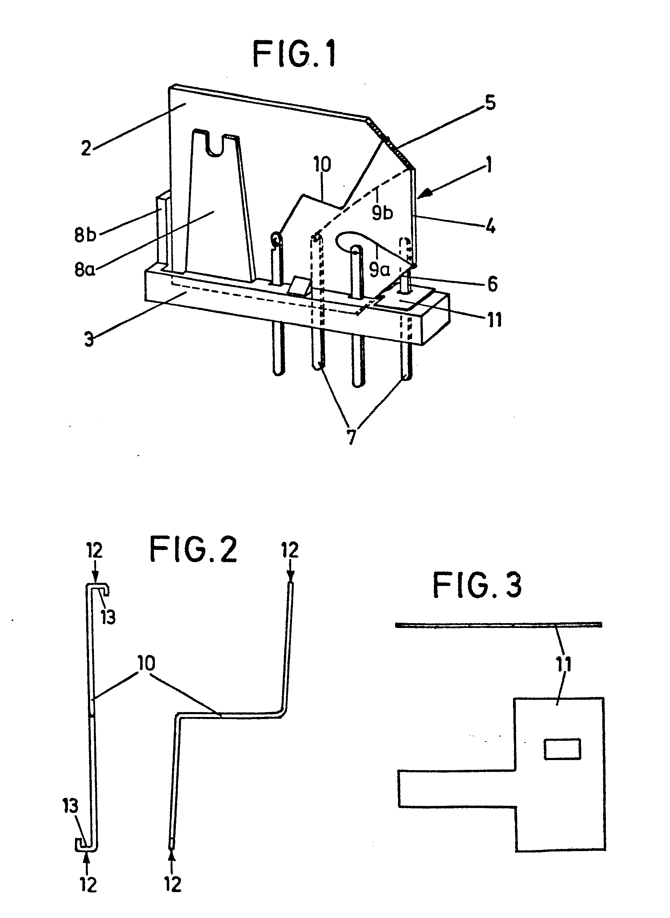

In der Figur 1 ist eine in vergrößerter Form gezeichnete Ultraschall-Verzögerungsleitung 1 dargestellt,
die im wesentlichen aus einem Festkörper 2 und einem
Kunststoffträger 3 besteht. Als Festkörper findet
bekannterweise ein ebener   dünner plattenförmiger
Glaskörper Verwendung, der eine Rechteckform mit im
wesentlichen parallel verlaufenden Außenflächen aufweist. Bei diesem Festkörper sind an einer der beiden
kleineren Außenseiten 4 beide gegenüberliegende Ecken
abgeschrägt. An diesen Schrägflächen ist jeweils ein
elektromechanischer Wandler 5, 6 angeordnet. Der
Kunststoffträger 3 weist wenigstens pro Wandler zwei
Kontaktstifte 7 auf und ist mit Führungsstegen 8a, 8b
zur Halterung des Festkörpers 2 versehen. In bekannter Weise ist der auf dem Festkörper aufliegende
untere Anschluß des Wandlers über eine Draht-Lötverbindung 9a, 9b mit den zugeordneten Kontaktstiften 7
des Trägers 3 verbunden. Zur Kontaktierung der freiliegenden oberen Anschlüsse des Wandlers ist je ein
bewegbares Kontaktfederteil 10 und 11 vorgesehen,
wobei eines als Blattfeder und das andere als Z-förmige Drahtfeder ausgeführt ist. Die Z-förmige Drahtfeder kontaktiert hierbei den Wandler, der mit Abstand
gegenüber den Kontaktstiften 7 des Trägers 3 auf dem Festkörper angeordnet ist. Ferner ist das als Z-förmige Drahtfeder ausgebildete Kontaktfederteil derart geformt und in den zugeordneten Kontaktstift so eingehängt, daß der Festkörper auf den Träger unter Druck in einer vorgegebenen Lage gehalten ist.

Die Figur 2 zeigt das Z-förmige, aus Federdraht gefertigte Kontaktteil 10, wobei die beiden Enden als Haken 12 ausgebildet sind. Der innere Schenkel des Hakens ist hierbei als gerades Verbindungsstück 13 ausgeführt.

In der Figur 3 ist das zweite Kontaktteil 11, das als Blattfeder ausgebildet ist, dargestellt. Die Blattfeder wird mittels eines eingebrachten Schlitzes auf einen zugeordneten Lötstift aufgesteckt und schmiegt sich an den oberen Anschluß des Wandlers an.

Die Kontaktfederteile 10, 11 berühren die Wandler durch ihre Formgebung derart, daß eine einwandfreie jedoch geringfügig verschiebbare Kontaktstelle gewährleistet ist.

ULTRASCHALL-VERZÖGERUNGSLEITUNG

PATENTANSPRÜCHE

1. Ultraschall-Verzögerungsleitung mit Mehrfachreflexion aus einem Festkörper mit Verzögerungseigenschaften, der zu einer dünnen ebenen Platte ausgebildet ist und der vorzugsweise eine Rechteckform mit im wesentlichen parallel verlaufenden Außenflächen aufweist, bei dem an einer der beiden kleineren Außenseiten beide gegenüberliegende Ecken abgeschrägt sind und an diesen Schrägflächen jeweils ein in einer Richtung polarisierter Eingangs- bzw. Ausgangs-Wandler angebracht ist, und der Festkörper in einem Kunststoffträger mit Kontaktstiften eingesetzt ist, wobei die beiden Wandler mit den Kontaktstiften elektrisch kontaktierend verbunden sind, d a d u r c h   g e -k e n n z e i c h n e t ,   daß der auf dem Festkörper (2) aufliegende untere Anschluß des Wandlers (5, 6) in bekannter Weise über eine Draht-Lötverbindung (9a,

- 2 -

9b) mit den zugeordneten Kontaktstiften (7) des Trägers (3) verbunden ist, während der freiliegende
obere Anschluß über ein auf den Wandler (5, 6) einen
bestimmten Druck ausübendes und längs des Wandlers
bewegbares Kontaktfederteil (10, 11) mit den zugeordneten Kontaktstiften (7) kontaktierbar ist.

2. Ultraschall-Verzögerungsleitung nach Anspruch 1, d a d u r c h   g e k e n n z e i c h -
n e t ,   daß eines der beiden Kontaktfederteile (11)
des Wandlers (6) als Blattfeder und das andere Kontaktfederteil (10) als Z-förmige Drahtfeder ausgeführt ist.

3. Ultraschall-Verzögerungsleitung nach den
Ansprüchen 1 und 2, d a d u r c h   g e k e n n -
z e i c h n e t ,   daß der Wandler (5), der von dem
als Z-förmige Drahtfeder ausgebildeten Kontaktfederteil (10) kontaktiert ist, gegenüberliegend zu den
Kontaktstiften (7) des Trägers (3) auf dem Festkörper
(2) angeordnet ist.

4. Ultraschall-Verzögerungsleitung nach den
Ansprüchen 1 bis 3, d a d u r c h   g e k e n n -
z e i c h n e t ,   daß das als Z-förmige Drahtfeder
ausgebildete Kontaktfederteil (10) derart geformt und
mit dem zugeordneten Lötstift so verbunden ist, daß der Festkörper auf den mit Führungsstegen (8a, 8b) versehenen Träger (3) unter Druck in einer vorgegebenen Lage gehalten ist.

5. Ultraschall-Verzögerungsleitung nach Anspruch 1 bis 4,   d a d u r c h   g e k e n n z e i c h - n e t ,   daß die beiden Enden des Kontaktfederteils (10), das Z-förmig aus Federdraht gefertigt ist, als Haken (12) ausgebildet sind.

6. Ultraschall-Verzögerungsleitung nach Anspruch 5,   d a d u r c h   g e k e n n z e i c h n e t , daß der innere Schenkel der hakenförmigen Enden des Kontaktfederteils (10) als ein gerades Verbindungsstück (13) ausgeführt ist.

7. Ultraschall-Verzögerungsleitung nach einem der bisherigen Ansprüche,   d a d u r c h   g e - k e n n z e i c h n e t ,   daß die beiden Kontakt- federteile (10, 11) verboldet sind.

1|1

# FIG.1

# FIG.2

# FIG.3